# EUROPEAN PATENT APPLICATION

(11) **EP 2 685 180 A2**
(43) Date of publication of application: **15.01.2014**
(21) Application number: 13159454.1
(22) Date of filing: 15.03.2013
(51) Int. Cl.: F24J 3/08, F24D 3/18, F28D 15/00, F28D 15/02, H05K 7/20

(54) **Ground heat base station**

(30) Priority: 15.03.2012 FI 20120078
(71) Applicant: Lempiäinen, Jukka, 00140 Helsinki (FI)
(72) Inventor: Lempiäinen, Jukka, 00140 Helsinki (FI)
(74) Representative: Papula Oy

(57) **Abstract**

In addition to base stations, the base station equipment comprises, emergency power devices for the base station equipment (accumulators) and ventilation, heating and air conditioning equipment. The base station equipment produces heat, but additional heating is additionally needed in particular in cold areas. In addition, air conditioning is needed in warm weather to cool the base station equipment. The portion of heating and cooling in the consumption of electricity of the base station equipment may easily range from 1 to 3 kWh.

Thus, a ground heat base station is a base station site (equipment room) with the base station equipment combined with ground heat equipment in such a way that the heating and cooling of the base station site/equipment are provided by ground heat. This kind of a solution saves heating and cooling expenses of mobile telephone operators.

## Description

### BACKGROUND OF THE INVENTION

### Field of the invention:

The invention at hand relates to a ground heat base station.

### Description of the Related Art:

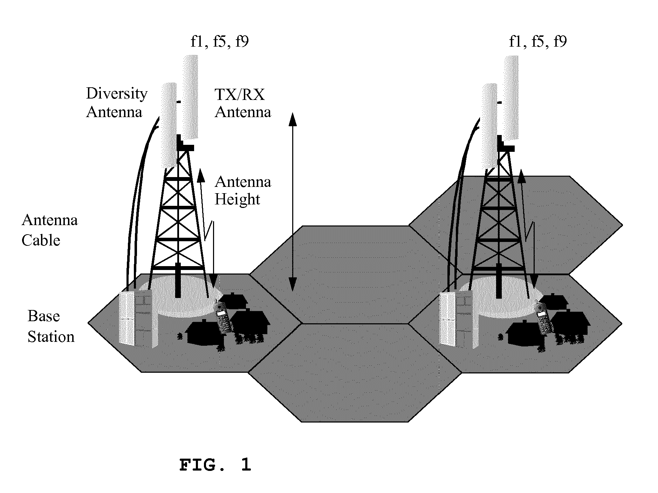

Radio networks include, a.o., mobile telephone networks (GSM/IS-95/UMTS/HSPA/CDMA2000/LTE/ TETRA), new broadband networks such as WiMAX or local area networks such as WLAN etc. and so-called "broadcast" networks such as television and DVB-H etc. All radio networks comprise base station equipment and a room wherein, a.o., the base stations are located (Fig. 1). Base stations are transmitter/receiver units providing a connection between a terminal device and the radio network based on the propagation of radio waves. This providing of the connection is also referred to as service area, i.e. coverage. The base station equipment also produces certain capacity/performance in its coverage area, meaning a certain number of calls or a certain amount of transmission capacity such as e.g. 42Mbit/s per two (dual carrier) UMTS/HSPA+ technology based transmitter/receiver pair-produced theoretical data transmission rate in the downlink direction.

In addition, the base station equipment essentially includes auxiliary equipment such as emergency power system and heating and air conditioning equipment. Typically, the emergency power system is provided by batteries, and there may also be separate generator sets in some cases.

Heating can be provided by a variety of solutions, such as district heating (in cities), electric heaters etc. depending on where the base station equipment is sited. Should the base station equipment be located outside the city, it often requires a separate protective booth, in which case the heating is often based on "direct electricity", i.e. electric heater. In addition, cooling is provided by various solutions generally based on different types of fans. Both - heating and cooling - consume a great deal of electrical energy (typically 1 - 3 kWh).

### SUMMARY OF THE INVENTION:

According to an aspect of the invention, the invention is a ground heat base station. The ground heat base station is characterized in that ground heat equipment is used to heat and cool the base station equipment and base station equipment room.

### BRIEF DESCRIPTION OF THE DRAWINGS:

Figure 1 illustrates a base station and related equipment and theoretical service area.
Figure 2 illustrates a base station equipment together with ground heat equipment.

### DETAILED DESCRIPTION OF THE EMBODIMENTS:

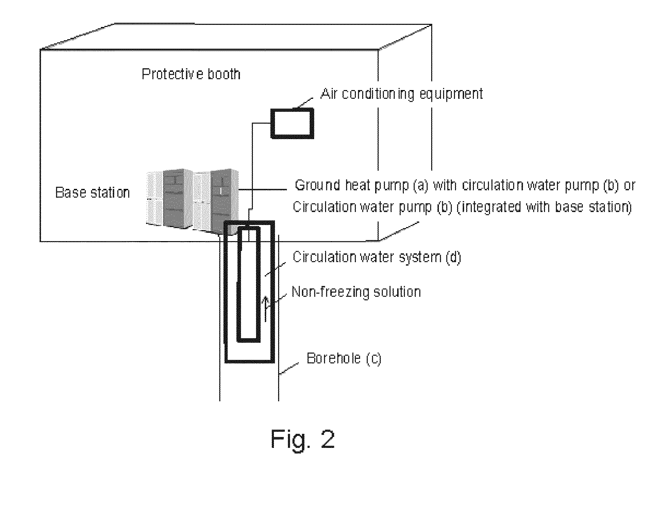

A ground heat base station is a base station site wherein the base station equipment is formed by the normal base station equipment of any radio network and by ground heat equipment (Fig. 2). The ground heat equipment is sized to be suitable for the base station site and accommodated in the same space with the base station equipment.

The ground heat equipment, i.e. a ground heat pump with a borehole, can be used to heat and cool the protective booth/room for the base station equipment. The ground heat pump requires electrical energy to produce specific heating energy by utilizing the energy released from the ground, i.e. borehole, in a ratio of 1:3. Respectively, in order to cool the room, only the borehole is required for circulating a non-freezing solution (e.g. alcoholic substances) in the piping further through air conditioning equipment. In the cooling, only a circulation water pump which is provided in the base station equipment is required.

Should only heating or heating and cooling both be required, the equipment includes a ground heat pump (a) with the circulation water pump (b) as well as a borehole (c) and circulation water system (d). Should only cooling be required, the equipment only includes the circulation water pump (b) as well as the borehole (c) and the circulation water system (d).

The ground heat pump and borehole save appr. 65% of electrical energy required in heating during cold weather and appr. 90% in cooling during warm weather.

## Claims

1. A ground heat base station is **characterized in that** ground heat equipment is used to heat and cool the base station equipment and base station equipment room.

2. A method according to claim 1 is **characterized in that** the base station equipment and ground heat equipment are provided in the same base station equipment room which may be a separate room in a larger building or a separate protective booth outdoors.

3. The method according to claim 1 is **characterized in that** the base station equipment must be kept in a protected space, be it a separate room as part of a building or a completely separate outbuilding such as a booth or the like.

4. The method according to claim 1 is **characterized in that** the base station equipment and room belong to equipment for transmission in wireless communications such as to the operators of mobile telephone, TV/radio, emergency systems.

5. A system according to claim 1 is **characterized in that** the ground heat equipment includes a ground heat pump (a), a circulation water pump (b), a borehole (c) and a circulation water system (d).

6. The method according to claim 1 is **characterized in that**, in order to cool the base station equipment and base station equipment room, only the circulation water pump (b) connected to the base station equipment, the borehole (c) and the circulation water system (d), which are further connected to air conditioning equipment, are required.

7. The system according to claim 1 is **characterized in that** a non-freezing solution is used in the circulation water system conducted through the borehole.

8. The method according to claim 1 is **characterized in that** the base station equipment room may include several items of base station equipment.

9. The method according to claim 1 is **characterized in that** it may be located in a city or rural area.
